# EUROPEAN PATENT APPLICATION

(11) **EP 4 565 011 A1**
(43) Date of publication of application: **04.06.2025**
(21) Application number: 23859010.3
(22) Date of filing: 31.07.2023
(51) Int. Cl.: H05K 1/02, H05K 3/00

(54) **PRINTED CIRCUIT BOARD, ELECTRONIC DEVICE, AND PRINTED CIRCUIT BOARD PREPARATION METHOD**

(30) Priority: 29.08.2022 CN 202211038535
(71) Applicant: ZTE CORPORATION, Shenzhen, Guangdong 518057 (CN)
(72) Inventor: XIE, Jian, Shenzhen, Guangdong 518057 (CN); WEI, Zhongmin, Shenzhen, Guangdong 518057 (CN); REN, Xiaoying, Shenzhen, Guangdong 518057 (CN)
(74) Representative: Canzler & Bergmeier Patentanwälte Partnerschaft mbB
(86) International application number: PCT/CN2023/110088
(87) International publication number: WO 2024/045975

(57) **Abstract**

An electronic device, a printed circuit board, and a printed circuit board preparation method. The printed circuit board comprises a layer structure body, a transmission line (1), which is used for transmitting a signal, and at least two plated-through holes (2), which penetrate through the layer structure body, wherein the transmission line (1) is located in the layer structure body, and the two ends of the transmission line (1) are directly connected to hole walls of the two plated-through holes (2), respectively.

## Description

### CROSS-REFERENCE TO RELATED APPLICATIONS

This application claims priority from Chinese patent application No. 202211038535.9 filed on August 29, 2022, the entirety of which is incorporated hereby by reference.

### TECHNICAL FIELD

The present disclosure relates to the technical field of printed circuits, and in particular, relates to a printed circuit board, an electronic device, and a method for preparing a printed circuit board.

### BACKGROUND

A printed circuit board (PCB) product with a rate up to 112Gbps has already begun to be commercialized, while a PCB product with a rate up to 224Gbps is still under development and has been confronted with a major technical problem: how to improve signal integrity (SI) performance of the system and increase the related bandwidth. As an important component in the system, the printed circuit board determines the performance of the system to a great extent.

How to reduce passive loss of the printed circuit board is a current research hotspot in the technical field of printed circuit boards, while a metallized through hole is an important part of a passive channel. Currently, in the existing art, a metallized through hole is typically connected to a transmission line so that the transmission line inside the PCB is led to an outer layer through the metallized through hole, to be connected to a chip pin or a connector pin or the like to form a complete signal transmission path. The PCBs in the existing art have the problems of relatively poor signal transmission integrity, relatively high signal loss and the like.

### SUMMARY

In an aspect, an embodiment of the present disclosure provides a printed circuit board, including a layer structure body, a transmission line for transmitting signals, and at least two metallized through holes penetrating through the layer structure body, the transmission line being in the layer structure body, and having two ends directly connected to walls of two metallized through holes, respectively.

In another aspect, an embodiment of the present disclosure further provides an electronic device, including the printed circuit board as described above.

In still another aspect, an embodiment of the present disclosure further provides a method for preparing the printed circuit board as described above, including: performing signal simulation of the printed circuit board, and determining a target region of the printed circuit board according to a simulation result of the signal simulation, the target region being a region where a parameter indicating signal integrity performance fails to satisfy a preset condition; and preparing the printed circuit board, with the metallized through holes being in the target region.

### BRIEF DESCRIPTION OF DRAWINGS

FIG. 1 is a schematic sectional view of a printed circuit board according to an embodiment of the present disclosure;
FIG. 2 is a schematic diagram illustrating a connection between a metallized through hole and a transmission line according to an embodiment of the present disclosure;
FIG. 3 is a top view of a printed circuit board according to an embodiment of the present disclosure;
FIG. 4 is a schematic comparison between insertion loss effects of a printed circuit board in the existing art and a printed circuit board according to an embodiment of the present disclosure; and
FIG. 5 is a schematic comparison between return loss effects of a printed circuit board in the existing art and a printed circuit board according to an embodiment of the present disclosure.

### DETAIL DESCRIPTION OF EMBODIMENTS

Exemplary embodiments will be described more sufficiently below with reference to the accompanying drawings, but the embodiments may be embodied in different forms and the present disclosure should not be construed as limited to the embodiments set forth herein. These embodiments are provided so that the present disclosure will be more thorough and complete, and will fully convey the scope of the present disclosure to those skilled in the art.

As used herein, the term "and/or" includes any and all combinations of one or more of the associated listed items.

The terminology used herein is for the purpose of describing specific embodiments only, instead of limiting the present disclosure. As used herein, the singular forms "a", "an" and "the" include the plural forms as well, unless the context clearly indicates otherwise. It will be further understood that as used herein, the terms "comprise/include" and/or "consist of ..." specify the presence of specific features, integers, steps, operations, elements, and/or components, but do not preclude the presence or addition of one or more other features, entities, steps, operations, elements, components, and/or groups thereof.

Embodiments described herein may be described with reference to plan and/or sectional views in idealized representations of the present disclosure. Accordingly, the example illustrations may be modified in accordance with the manufacturing process and/or the tolerance. Therefore, the embodiments are not limited to the embodiments shown in the drawings, but further include modifications of configurations formed based on a manufacturing process. Thus, the regions illustrated in the figures have schematic properties, and the shapes of the regions shown in the figures illustrate specific shapes of regions of elements, but are not intended to be limitative.

Unless otherwise defined, all terms (including technical and scientific terms) used herein have the same meaning as commonly understood by one of ordinary skill in the art. It will be further understood that terms, such as those defined in commonly used dictionaries, should be interpreted as having a meaning that is consistent with their meaning in the context of the existing art and the present disclosure, and will not be interpreted in an idealized or overly formal sense unless expressly so defined herein.

In the existing art, a metallized through hole is typically connected to a transmission line so that the transmission line inside the PCB is led to an outer layer of the PCB through the metallized through hole, to be connected to a chip pin or a connector pin or the like to form a complete signal transmission path. A direction in which a signal is transmitted is as follows: signal input (e.g., a chip terminal) → metallized through hole → external pad → transmission line → via pad → metallized through hole → signal output. In the scheme for connecting the metallized through hole to the transmission line, the metallized through hole is connected to the transmission line through a via pad, which may affect impedance continuity and signal integrity to cause problems such as resulting in a relatively high signal loss.

Embodiments of the present disclosure provide a printed circuit board and a method for preparing a printed circuit board, by removing the via pad inside the PCB, the metallized through hole is directly connected to the transmission line, which facilitates impedance continuity of a signal transmission, thereby improving signal integrity.

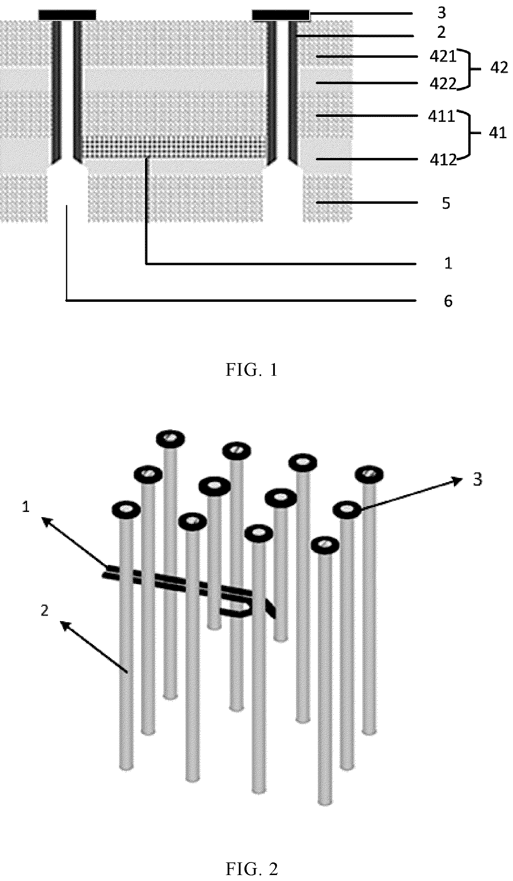

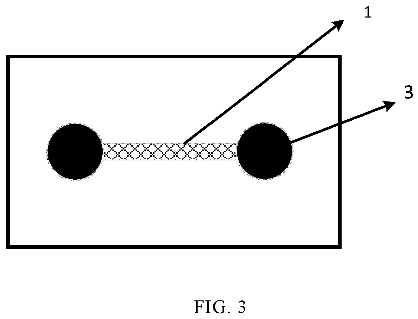

FIG. 1 is a schematic sectional view of a printed circuit board according to an embodiment of the present disclosure, FIG. 2 is a schematic diagram illustrating a connection between a metallized through hole and a transmission line according to an embodiment of the present disclosure, and FIG. 3 is a top view of a printed circuit board according to an embodiment of the present disclosure. As shown in FIGs. 1 to 3, an embodiment of the present disclosure provides a printed circuit board including a layer structure body, a transmission line 1 for transmitting signals, and at least two metallized through holes 2 penetrating through the layer structure body. The transmission line 1 is located in the layer structure body, and has two ends directly connected to walls of two metallized through holes 2, respectively.

In the printed circuit board according to the embodiment of the present disclosure, the metallized through holes 2 are located in a ball grid array (BGA) region and/or a connector region of the layer structure body, and the metallized through holes 2 are equally spaced. Each metallized through hole 2 is formed by rotating a drill bit on the layer structure body at a high speed to form a hole structure, and then forming metal on the hole structure through electroplating or chemical plating, the metal for the metallized through hole 2 is generally copper. The transmission line 1 may be made of metallic copper, or may be formed by etching a core board containing copper, or may be a copper wire. It should be noted that the transmission line 1 and the metallized through hole 2 are in one circuit loop.

The layer structure body may be of a single-layer structure, i.e., may be a single-layer PCB, or may be of a multi-layer structure, i.e., may be a multi-layer PCB. In the printed circuit board according to the embodiment of the present disclosure, as shown in FIG. 1, a layer structure body of a multi-layer structure is taken as an example for explanation, and the printed circuit board is a multi-layer board.

The printed circuit board according to the embodiment of the present disclosure includes a layer structure body, a transmission line 1 for transmitting signals, and at least two metallized through holes 2 penetrating through the layer structure body. The transmission line 1 is located in the layer structure body, and has two ends directly connected to walls of two metallized through holes 2, respectively. According to the embodiment of the present disclosure, no via pad is provided in the layer structure body so that the transmission line 1 is directly connected to the walls of the metallized through holes 2, which can reduce impedance mismatching, signal insertion loss and return loss, and improve signal integrity.

In some implementations, the two ends of the transmission line 1 are connected to outer walls of the two metallized through holes 2, respectively, by electroplating.

To avoid the problem of cracking caused by a faster chemical reaction at positions corresponding to the metallized through holes 2 than at other positions in the electroplating process, a connection position between each metallized through hole 2 and the transmission line 1 may be additionally compensated, i.e., a width (the vertical size in a direction of up and down in FIG. 3) of the transmission line 1 at the connection position may be increased, an increased size of the width is dependent on the capability of technological level. Therefore, in some implementations, both ends of the transmission line 1 each have a width greater than other parts of the transmission line 1 not connected to the two metallized through holes 2.

In some implementations, as shown in FIGs. 1 and 2, the printed circuit board further includes pads 3. The number of the pads 3 is the same as the number of the metallized through holes 2. The pads 3 are located on a first surface of the layer structure body and electrically connected to a signal input or signal output of the printed circuit board, and the pads 3 cover the metallized through holes 2 respectively, and are connected to the walls of the respective metallized through holes 2. The pads 3 are typically made of a material of copper.

In some implementations, the printed circuit board is a multi-layer board, and accordingly, as shown in FIG. 1, the layer structure body includes a first layer structure 41 and at least one second layer structure 42, and the at least one second layer structure 42 and the first layer structure are arranged in a stack. The transmission line 1 is located in the first layer structure 41, and the first layer structure 41 and the second layer structure 42 may be core boards. In the printed circuit board according to the embodiment of the present disclosure, one second layer structure 42 is taken as an example for explanation. In the printed circuit board shown in FIG. 1, the second layer structure 42 is located on a side of the first layer structure 41 proximal to the pads 3, and the first surface of the layer structure body is a surface of the second layer structure 42 away from the first layer structure 41.

In some implementations, the second layer structure 42 includes a third dielectric layer 421 and a fourth dielectric layer 422 which are arranged in a stack, and the fourth dielectric layer 422 is located on a side of the third dielectric layer 421 away from the pads 3. The first layer structure 41 includes a first dielectric layer 411 and a second dielectric layer 412 which are arranged in a stack, and the first dielectric layer 411 is located on a side of the second dielectric layer 412 proximal to the pads 3.

In some implementations, the printed circuit board is a single-layer board, and accordingly, the layer structure body includes a first layer structure, and the first layer structure includes a first dielectric layer and a second dielectric layer which are arranged in a stack. In this case, the first surface of the layer structure body is a surface of the first dielectric layer away from the second dielectric layer, and the transmission line is located in the second dielectric layer. In other words, compared with the multi-layer printed circuit board, the single-layer printed circuit board lacks the second layer structure 42 and has only the first layer structure 41.

In some implementations, as shown in FIG. 1, the printed circuit board further includes a fifth dielectric layer 5 on a side of the layer structure body away from the pads 3. Back drilled holes 6, penetrating through the fifth dielectric layer 5 and in communication with the metallized through holes 2, are formed at positions of the fifth dielectric layer 5 corresponding to the metallized through holes 2.

In some implementations, each dielectric layer is typically composed of resin, glass fibers, fillers, or the like.

If the transmission line is deployed with a same width in a same plane, the impedance thereof remains unchanged, so that signals can be transmitted indiscriminately, signal reflection can be reduced, and signal quality can be ensured to a maximum extent. However, if the transmission line performs transmission by penetrating through any layer, the impedance of the transmission line will change, resulting in increased reflection and increased signal loss as well as poor quality of the transmitted signal. A signal is transmitted through the metallized through hole penetrating through a layer to be connected to the transmission line. If the signal is input at a first layer of a four-layer printed circuit board, and is output at a third layer of the printed circuit board through the metallized through hole, signal loss may be caused by a stub (i.e., metallized copper) of the metallized through hole between the third layer and a fourth layer of the printed circuit board. Therefore, in the printed circuit board according to the embodiment of the present disclosure, the back drilled holes 6 are used to remove the unexpected/surplus metallized copper of the metallized through hole 2 on a side of the second dielectric layer 412 away from the pads 3, thereby reducing signal loss and improving signal transmission quality.

Simply from a design of the pads, the embodiment of the present disclosure takes both signal integrity and designability into consideration, and solves the problem that high performance cannot be achieved due to a signal distortion in a via in the existing art.

An embodiment of the present disclosure further provides an electronic device, including the printed circuit board as described above.

An embodiment of the present disclosure further provides a method for preparing the printed circuit board as described above. The method includes following operations S11 and S12.

At operation S11, performing signal simulation of the printed circuit board, and determining a target region of the printed circuit board according to a simulation result of the signal simulation, the target region is a region where a parameter indicating signal integrity performance fails to satisfy a preset condition. It should be noted that the target region is a part or all of a BGA region and/or a connector region of the printed circuit board.

In this operation, signal simulation of the printed circuit board is performed according to design expectations to position a target region with relatively high signal loss, e.g., a region where the simulation result indicates that the impedance of the metallized through hole is discontinuous and the parameter indicating signal integrity performance fails to satisfy a preset condition.

In some implementations, the parameter indicating signal integrity performance includes insertion loss and/or return loss.

At operation S12, preparing the printed circuit board, with the metallized through holes being in the target region.

It should be noted that, for the target region, the signal loss may be firstly reduced by reducing a diameter of the metallized through hole, adjusting a width of the transmission line, and the like, and under the condition that the above methods fail, the via pad inside the layer structure body is then removed to directly connect the transmission line 1 to walls of the metallized through holes 2.

In the process of preparing the printed circuit board, GERBER data is firstly created and designed by electronic design automation (EDA) software, by following operations.
1. Fabricating network layout, i.e., arranging various electronic components according to a design schematic diagram.
2. Establishing network connections, i.e., connecting various components by connection lines to form a complete network architecture diagram.
3. Creating pad-free data, i.e., performing via pad optimization in the BGA region and/or the connector region provided with the metallized through hole by eliminating the via pad or adjusting a size of the via pad to conform to a diameter of the metallized through hole.
4. Outputting a GERBER file, i.e., outputting a GERBER file in a general format with a suffix recognizable by printed circuit board manufacturers.

After the GERBER data is completed, a printed circuit board without any via pad is prepared, by following operations.
1. Finding a pad-free signal hole in the PCB design data.
2. Transferring and forming a pattern on an inner core board, i.e., performing processes like film lamination, exposure, development on an inner core board to complete a transfer of an inner layer pattern, and forming a pattern of the transmission line on the inner core board.
3. Pressing and laminating, i.e., superposing and laminating a prepreg and the inner core board formed to form a multi-layer PCB.
4. Drilling, i.e., performing mechanical drilling according to general design expectations, with a diameter of the hole drilling cutter being equal to a diameter of the designed hole, and thus obtaining a back drilled hole.

With the method according to the embodiment of the present disclosure, a target region with relatively high signal loss is positioned through signal simulation, and in the target region, the via pad in the layer structure body is removed, so as to directly connect the transmission line 1 to walls of the metallized through holes 2, which can reduce impedance mismatching, signal insertion loss and return loss, and improve signal integrity.

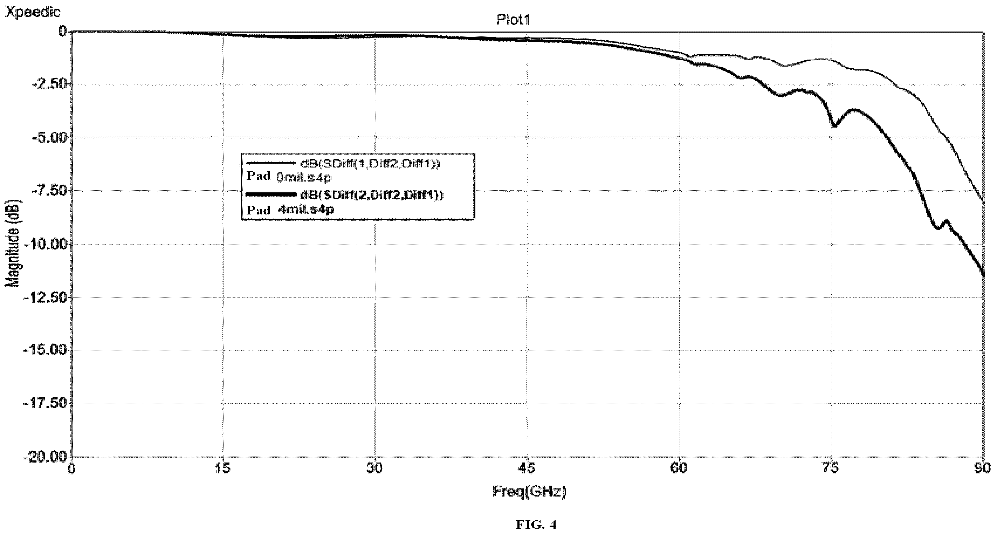

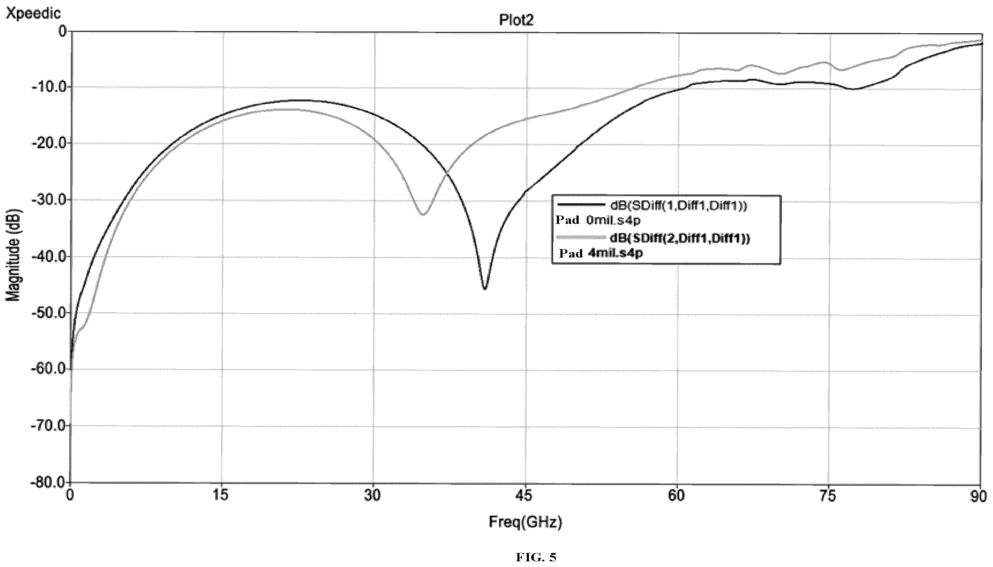

It should be noted that, instead of removing the pad in the layer structure body in the target region, no via pad may be provided in the layer structure body throughout the printed circuit board, so that a design of the printed circuit board entirely free of via pads is achieved. FIG. 4 is a schematic comparison between insertion loss effects of a printed circuit board in the existing art and a printed circuit board according to an embodiment of the present disclosure; and FIG. 5 is a schematic comparison between return loss effects of a printed circuit board in the existing art and a printed circuit board according to an embodiment of the present disclosure. The test experimental effects of embodiments of the present disclosure will be described below with reference to FIGs. 4 and 5.

As shown in FIG. 4, the lower thick solid curve in the figure is a curve of signal insertion loss of a PCB with a via pad in a size of 4 mils in the existing art, the upper thin solid curve is a curve of signal insertion loss of a PCB according to an embodiment of the present disclosure, and in FIG. 4, the x-axis represents frequency and the y-axis represents insertion loss. As can be seen from FIG. 4, at a higher frequency, the curve of signal insertion loss of the PCB according to the embodiment of the present disclosure is closer to 0, indicating a lower signal loss.

As shown in FIG. 5, the curve with a light color in the figure is a curve of signal return loss of a PCB with a via pad in a size of 4 mils in the existing art, the curve with a dark color is a curve of signal return loss of a PCB according to an embodiment of the present disclosure, and in FIG. 5, the x-axis represents frequency and the y-axis represents return loss. As can be seen from FIG. 5, at a higher frequency, the signal return loss of the PCB in the existing art is closer to 0, indicating a higher signal loss.

The printed circuit board according to the embodiment of the present disclosure can improve impedance matching without increasing the complexity and difficulty of the process for preparing the printed circuit board, so that factors resulting in impedance mismatching can be reduced at the input and the output, signal integrity of the metallized through hole can be greatly improved, and signal loss can be reduced, thereby solving the problem of taking both signal integrity and designability of the metallized through hole into consideration under an expectation of high-speed transmission.

The embodiments of the present disclosure are suitable for designing high-speed printed circuit board products, especially wired and wireless products with a rate of 224Gbps or above, and may be applied to printed circuit boards with a designed rate of 224Gbps or above, or printed circuit boards with a designed rate lower than 224Gbps but desiring relatively low signal loss.

Those of ordinary skills in the art will appreciate that all or some operations of the method, functional modules/units in the apparatus described above may be implemented as software, firmware, hardware, and suitable combinations thereof. In a hardware implementation, the division between the functional modules/units mentioned in the above description does not necessarily correspond to the division of physical components; for example, one physical component may have multiple functions, or one function or operation may be performed cooperatively by several physical components. Some or all physical components may be implemented as software executed by a processor, such as a CPU, a digital signal processor or microprocessor, or implemented as hardware, or implemented as an integrated circuit, such as an application specific integrated circuit. Such software may be distributed on a computer-readable medium which may include a computer storage medium (or non-transitory medium) and a communication medium (or transitory medium). The term computer storage medium includes volatile and nonvolatile, removable and non-removable media implemented in any method or technology for storage of information such as computer-readable instructions, data structures, program modules or other data, as is well known to those of ordinary skill in the art. The computer storage medium includes, but is not limited to, an RAM, an ROM, an EEPROM, a flash or any other memory technology, a CD-ROM, a digital versatile disk (DVD) or any other optical disk storage, a magnetic cartridge, a magnetic tape, a magnetic disk storage or any other magnetic storage device, or may be any other medium used for storing the desired information and accessible by a computer. Moreover, it is well known to those ordinary skilled in the art that a communication medium typically includes a computer-readable instruction, a data structure, a program module, or other data in a modulated data signal, such as a carrier wave or other transport mechanism, and may include any information delivery medium.

The present disclosure has disclosed exemplary embodiments, and although specific terms are employed, they are used and should be interpreted merely in a generic and descriptive sense, not for purposes of limitation. **In** some instances, features, characteristics and/or elements described in connection with a particular embodiment may be used alone, or may be used in combination with features, characteristics and/or elements described in connection with other embodiments, unless expressly stated otherwise, as would be apparent to one skilled in the art. It will, therefore, be understood by those skilled in the art that various changes in form and details may be made without departing from the scope of the present disclosure as set forth in the appended claims.

## Claims

1. A printed circuit board, comprising a layer structure body, a transmission line for transmitting signals, and at least two metallized through holes penetrating through the layer structure body, wherein the transmission line is located in the layer structure body, and has two ends directly connected to walls of two metallized through holes, respectively.

2. The printed circuit board according to claim 1, wherein the two ends of the transmission line are connected to outer walls of the two metallized through holes, respectively, by electroplating.

3. The printed circuit board according to claim 1, further comprising a plurality of pads, a total number of the pads being the same as a total number of the metallized through holes, wherein the pads are located on a first surface of the layer structure body and electrically connected to a signal input or a signal output of the printed circuit board, and the pads cover the metallized through holes respectively, and are connected to the walls of the metallized through holes respectively.

4. The printed circuit board according to claim 3, wherein the layer structure body comprises a first layer structure, the first layer structure comprises a first dielectric layer and a second dielectric layer, the first dielectric layer and the second dielectric layer are arranged in a stack, the first surface is a surface of the first dielectric layer away from the second dielectric layer, and the transmission line is located in the second dielectric layer.

5. The printed circuit board according to claim 3, wherein the layer structure body comprises a first layer structure and at least one second layer structure, the at least one second layer structure and the first layer structure are arranged in a stack, the first surface is a surface of the second layer structure away from the first layer structure, and the transmission line is located in the first layer structure.

6. The printed circuit board according to claim 5, wherein the second layer structure comprises a third dielectric layer and a fourth dielectric layer, the third dielectric layer and the fourth dielectric layer are arranged in a stack, and the fourth dielectric layer is located on a side of the third dielectric layer away from the pads; and
the first layer structure comprises a first dielectric layer and a second dielectric layer, the first dielectric layer and the second dielectric layer are arranged in a stack, and the first dielectric layer is located on a side of the second dielectric layer proximal to the pads.

7. The printed circuit board according to claim 4 or 5, further comprising a fifth dielectric layer on a side of the layer structure body away from the pads, wherein
back drilled holes, penetrating through the fifth dielectric layer and in communication with the metallized through holes, are formed at positions of the fifth dielectric layer corresponding to the metallized through holes.

8. An electronic device, comprising the printed circuit board according to any one of claims 1 to 7.

9. A method for preparing a printed circuit board according to any one of claims 1 to 7, comprising:
performing signal simulation of the printed circuit board, and determining a target region of the printed circuit board according to a simulation result of the signal simulation, the target region being a region where a parameter indicating signal integrity performance fails to satisfy a preset condition; and
preparing the printed circuit board, with the metallized through holes being in the target region.

10. The method according to claim 9, wherein the parameter indicating signal integrity performance comprises at least one of insertion loss or return loss.
